# EUROPÄISCHE PATENTSCHRIFT

(11) **EP 0 715 408 B1**
(45) Veröffentlichungstag und Bekanntmachung des Hinweises auf die Patenterteilung: **02.07.2003**
(21) Anmeldenummer: 95117663.5
(22) Anmeldetag: 09.11.1995
(51) Int. Cl.: H03K 7/06, H03K 5/13, G06F 1/025

(54) **Taktgenerator zur Erzeugung eines störstrahlungsarmen Systemtaktes**
Clock generator to generate a system clock with low radiation
Générateur d'horloge pour générer une horloge d'un système à rayonnement réduit

(30) Priorität: 30.11.1994 DE 4442403
(43) Veröffentlichungstag der Anmeldung: 05.06.1996
(73) Patentinhaber: Micronas GmbH, 79108 Freiburg (DE)
(72) Erfinder: Theus, Ulrich, Dr.-Ing., D-79194 Gundelfingen (DE); Menkhoff, Andreas, D-79098 Freiburg (DE)

(56) Entgegenhaltungen:
- EP-A- 0 163 313
- EP-A- 0 326 643
- EP-A- 0 416 423
- DE-A- 3 823 018
- US-A- 4 507 796
- US-A- 4 933 890

## Beschreibung

Die Erfindung betrifft einen Taktgenerator zur Erzeugung eines im zeitlichen Mittel frequenzgenauen Systemtaktes für mindestens eine taktgesteuerte elektronische Einrichtung, insbesondere im Kraftfahrzeug. Bezüglich benachbarter, elektronischer Geräte sind der Systemtakt selbst und die resultierenden Stromspitzen störstrahlarm, da der Systemtakt mittels eines Phasenmodulators in Abhängigkeit von einer Signalquelle gegenüber einem Bezugstakt moduliert ist.

Die zunehmende Verwendung von digitalen, in der Regel taktgesteuerten Signalverarbeitungseinrichtungen in den verschiedensten Anwendungsbereichen, insbesondere auch in Kraftfahrzeugen, zur Anzeige, Steuerung oder Regelung unterschiedlichster Funktionen, bedingt ein zentrales oder dezentrales Taktsystem, an das die einzelnen taktgesteuerten Einrichtungen angeschlossen sind. Dadurch entstehen direkt oder über die angeschlossenen Versorgungs- oder Signalleitungen in einem großen Frequenzbereich Störsignale. Die Störsignale können sich dabei über elektromagnetische Störfelder, aber auch über ein relativ hochohmiges Versorgungsnetz, auf benachbarte elektronische Einrichtungen oder Geräte ausbreiten und diese stören. Besonders unangenehm sind diese Störungen, wenn sie sich auf analoge Schaltungsteile oder analoge Signale auswirken. Im Kraftfahrzeug ist hiervon insbesondere der Audiobereich mit Radio-, Funk- oder Kassettenbetrieb betroffen, aber auch analoge Meßwertaufnehmer können gestört werden.

Die Ursache der Störungen sind die resultierenden, steilflankigen Stromspitzen in den taktgesteuerten Einrichtungen, die durch eine oder beide Taktflanken des Systemtaktes ausgelöst werden. Sie entstehen durch die Aktivierung einer Vielzahl von Schaltstufen, z.B. bei MOS-Schaltungen durch die Auf- oder Entladung der betroffenen Gate-Kapazitäten. Je höher dabei die Taktfrequenz ist, desto schneller müssen die internen Schaltvorgänge ablaufen. Dies wird durch eine niederohmige Schaltungsauslegung erreicht, jedoch je niederohmiger die Schaltung wird, desto größer werden die Stromspitzen. Mit zunehmender Schaltungskomplexität nimmt die Anzahl der jeweils zu aktivierenden Schaltstufen und damit die Höhe der Stromspitzen weiter zu. Dies gilt insbesondere dann, wenn die zugehörigen taktgesteuerten Einrichtungen, z.B. Prozessoren, in CMOS-Technik realisiert sind. Die Pufferung der sehr schmalen Laststromspitzen durch externe Abblockkondensatoren ist aus Kostengründen und wegen der üblichen Gehäusebauarten für die integrierten Schaltungen nur unvollkommen möglich. Es lassen sich dabei kaum die hochfrequenten Anteile der Störsignale unterdrücken.

Aus dem Stand der Technik sind einige Verfahren bekannt, wie ein Taktsystem modifiziert werden kann, um die Störwirkungen auf benachbarte elektronische Geräte zu reduzieren. Maßnahmen, die der passiven Abschirmung oder der Verflachung der Flanken unnötig steiler Stromspitzen zuzurechnen sind, sind nicht Gegenstand der Erfindung, können jedoch auf vorteilhafte Weise mit ihr kombiniert werden und eine weitere Unterdrückung der Störwirkung bewirken. Die gattungsgemäße Erfindung betrifft eine Modulation der Taktfrequenz, die den Energieinhalt des Störsignals, nämlich der Stromspitzen, nicht auf eine diskrete Spektrallinie und ihre Harmonischen konzentriert, sondern den Energieinhalt auf einen größeren Frequenzbereich möglichst gleichmäßig verteilt. Im zeitlichen Mittel soll dabei die Taktfrequenz nicht von einem Bezugstakt mit feststehender Frequenz abweichen.

In DE-A-41 42 563 (= ITT-Case, C-DIT-1430) ist ein Taktgenerator beschrieben, der mittels eines Phasen/Frequenzmodulators den Systemtakt moduliert. Als Modulator dient ein elektronisch gesteuerter Leckstrompfad, der die VCO-Steuerspannung moduliert, wobei der gesteuerte Leckstrom beispielsweise ein Sägezahn-, Dreiecks-, Sinus- oder anderen Signalverlauf aufweisen kann. Ob eine Phasen- oder Frequenzmodulation vorliegt, hängt von der Dimensionierung der Phasenregelschleife und der Amplitude des Leckstromverlaufs ab.

In DE-A 38 02 863 werden die taktbedingten Störwirkungen durch eine reine Frequenzmodulation des Systemtaktes reduziert, wobei ein besonderer Augenmerk auf die jeweilige Modulationsfrequenz und den jeweiligen Frequenzhub im Hinblick auf den zu entstörenden Frequenzbereich gelegt wird.

In DE-A 44 23 074 (= ITT-Case, C-DIT-1666) wird zur Reduzierung der taktbedingten Störwirkung das Ausgangssignal eines Taktgenerators mittels eines Frequenzteilers zwischen mindestens zwei Teilungsverhältnissen so umgeschaltet, daß im zeitlichen Mittel ein frequenzgenaues Taktsignal vorliegt. Die Umschaltung des Frequenzteilers erfolgt durch einen Pseudozufallszahlengenerator.

In US-A 4 023 116 wird ein Frequenzsynthese-System beschrieben, dessen Ausgangstakt über eine Phasenregelschleife an einen impulsförmigen Referenztakt gekoppelt ist. Da der Phasenvergleich nur während der Taktflanken des Referenztaktes möglich ist, wirkt sich der Zeitbereich zwischen den Taktflanken auf die Phasen/Frequenzregelung als "Totband" aus. Während des Totbandintervalls ist das Frequenzsynthesesystem ungeregelt und es können daher kleine, ungeregelte Schwankungen in der Ausgangsperiode als störende Phasendifferenzen auftreten. Durch Schaltungsmaßnahmen wird das Totband beseitigt und damit das Frequenzzittern des synthetisierten Ausgangssignals beruhigt.

Bei den beschriebenen Taktgeneratoren werden Verfahren verwendet, die die Hauptspektrallinien des störenden Spektrums reduzieren, indem ihr Energieinhalt auf weitere Spektrallinien verteilt wird. Eine genaue Analyse der resultierenden Signalspektren durch den Erfinder zeigt jedoch die Ursache für die mangelhafte Entstörwirkung der beschriebenen Verfahren, die nicht verhindert können, daß einzelne Spektrallinien nach wie vor deutlich höhere Amplituden aufweisen als die restlichen Spektrallinien, wodurch die Entstörwirkung leider begrenzt wird. Ursache dieser hervorgehobenen Spektrallinien sind periodische Signalkomponenten im Modulationssignal selbst, z.B. bei der Dreiecks- oder Sägezahnmodulation, oder eine Modulationskomponente, die zwar nicht periodisch ist, z.B. eine Pseudozufallszahlenfolge, bei der jedoch die Anzahl der zusätzlichen Spektrallinien viel zu gering und ihre Lage ungünstig ist.

Nach der US-A-4,933,890 werden die Flanken eines Ausgangtaktsignals, das von einem numerisch-Kontrollierten Oszillator erzeugt wird, durch kontrollierte Synchronisierung mit einem D-Flipflop so korrigiert, daß sie besser mit dem idealisierten Signal der gewünschten Frequenz übereinstimmen.

Hierzu wird der Takt für den numerisch-Kontrollierten Oscillator über den Abgriff einer Verzögerungsleitung auf den Takteingang des D-Flipflops gegeben, während das zu korrigierende Ausgangstaktsignal am Dateneingang anliegt. Periodische Phasenvariation werden weiterhin dadurch unterdrückt, daß die Wahl des Abgriffs der Verzögerungsleitung von einem Zufallsgenerator mit beeinflußt wird.

Es ist daher Aufgabe der Erfindung, einen verbesserten Taktgenerator zur Erzeugung eines störstrahlarmen Systemtaktes anzugeben, dessen Störspektrum und damit dessen abgestrahlte Energie möglichst. gleichmäßig auf viele Spektrallinien verteilt ist. Diese Aufgabe wird erfindungsgemäß mit einem Taktgenerator mit den in Anspruch 1 beanspruchten Merkmalen gelöst. Vorteilhafte Weiterbildungen ergeben sich aus den Merkmalen der Unteransprüche.

Die Erfindung und ihre Weiterbildungen werden nun anhand der Figuren der Zeichnungen näher erläutert:
Fig. 1 zeigt als Blockschaltbild einen Taktgenerator nach der Erfindung,
Fig. 2 veranschaulicht schematisch über einige Taktperioden den zeitlichen Zusammenhang zwischen dem Taktsignal und den resultierenden Stromspitzen,
Fig. 3 und Fig. 4 zeigen als Blockschaltbilder jeweils einen Taktgenerator mit einem digital gesteuerten Verzögerungsnetzwerk als Phasenmodulator und
Fig. 5 und Fig. 6 zeigen schematisch zwei Spektren, der Stromspitzen.

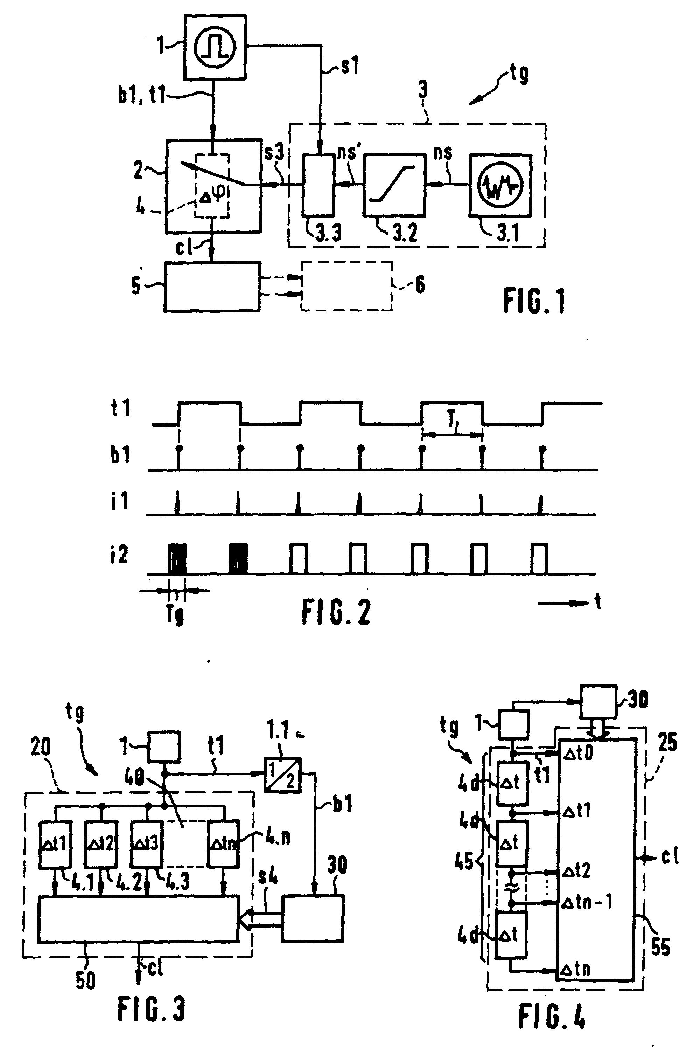

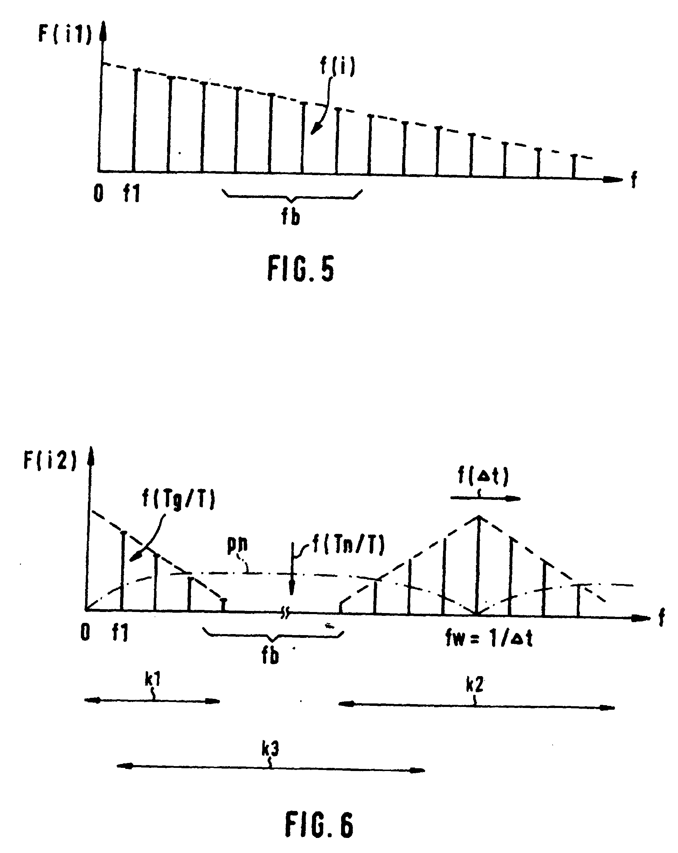

Der Taktgenerator nach Fig. 1 enthält alle Schaltungselemente, die zur Realisierung der Erfindung mittels eines Phasenmodulators erforderlich sind. Aus einer über die Fourier-Analyse abgeleiteten Betrachtung der Signalspektren der beiden Stromspitzenfolgen i1, i2 (vgl. Fig. 2) ergeben sich nämlich folgende Abhängigkeiten für die resultierenden Spektren. Vereinfachend wird hierbei angenommen, daß die einzelnen Stromspitzen i1 bzw. i2 so schmal sind, daß sich ihre Störspektren bis in einen Frequenzbereich erstrecken, der mindestens um den Faktor 10 größer als die Frequenz des zugehörigen Bezugstaktes b1 ist. Das Spektrum einer in der Frequenz und Phase festen Impulsfolge, die den Stromspitzen i1 entspricht, enthält bekanntlich die Harmonischen des Bezugstaktes b1, wobei die einzelnen Amplituden nur geringfügig mit der Frequenz abnehmen. Das Spektrum einer phasenmodulierten Impulsfolge, die den Stromspitzen i2 entspricht, verläuft anders - folgende drei Hauptabhängigkeiten beeinflussen es:
1. Das kleinste gemeinsame Vielfache der inversen Verzögerungszeiten aller auftretenden Verzögerungen Δt legt fest, mit welcher Frequenz sich das gesamte Spektrum wiederholt. Ist kein solches gemeinsames Vielfach vorhanden, dann entspricht dies dem Idealfall, bei dem überhaupt keine Wiederholung des Spektrums auftritt. Dieser Betriebsfall ist angenähert nur mit einer Zufallssignalquelle 3.1 erreichbar, deren Ausgangssignal n ein analoges, aperiodisches Rauschsignal ist, das einen Phasenmodulator 2 mit unendlich feiner Zeitauflösung steuert. Für die praktische Anwendung reicht es jedoch aus, wenn sich das Spektrum erst ab einer ausreichend hohen Frequenz f wiederholt, bzw. gespiegelt wird. Der inverse Wert 1/f dieser Frequenz f liefert einen Zeitwert Δt = 1/f, der den zugehörigen kleinsten Quantisierungsschritt für alle Phasenverschiebungen darstellt. Dieser Zeitwert Δt kann besonders einfach mittels einer geschalteten Verzögerungseinrichtung 40 bzw. 45, z.B. einem Verzögerungsnetzwerk nach Fig. 3 oder Fig. 4, realisiert werden. Liegt Δt im Bereich weniger Nanosekunden, so wiederholt sich das Spektrum theoretisch erst nach mehreren hundert Megahertz. In der Regel sind jedoch die Flanken der Stromspitzen hierfür nicht steil genug, so daß das Störspektrum bei diesen Frequenzen nicht mehr vorhanden ist. Der Zeitpunkt Δt entspricht nach seiner Normierung auf die Bezugsperiode T der jeweiligen Phasendifferenz Δϕ.
2. Das Verhältnis der längsten Verzögerung Tg/2 zur Periodendauer T des Bezugstaktes b1 legt fest, wie stark die Oberwellen im Spektrum gedämpft werden, bis sie letztendlich als diskrete Spektrallinien nicht mehr aus dem gleichförmigen Rauschen herausragen - damit sind sie nicht mehr identifizierbar.
3. Die Länge der Zufallszahlenfolge ohne Wiederholung legt fest, wie dicht die einzelnen Spektrallinien beieinander liegen. Wenn die Zufallszahlenfolge eine definierte Wiederholungsrate aufweist, was in der Regel bei digitalen Zufallssignalgeneratoren der Fall ist, dann handelt es sich um eine Pseudozufallszahlenfolge. Da andererseits die zeitliche Länge Tn der Zufallszahlenwiederholung über die Realisierung des digitalen Zufallszahlengenerators beliebig vorgegeben werden kann, ist auch die Dichte der Spektrallinien beliebig vorgebbar. Wie eingangs erwähnt, hängt von der Anzahl der Spektrallinien ab, auf wieviele Spektrallinien sich die Störenergie verteilen kann. Eine ausreichende Dichte der Spektrallinien beginnt etwa ab einer Feinstruktur, die feiner als ein Zehntel der Bezugstaktperiode T ist.

Folgendes Beispiel soll zur Erläuterung dienen: Ein Taktgenerator erzeugt einen Rechtecktakt mit 5 MHz. Die positive und negative Taktflanke bewirken in den taktgesteuerten Einrichtungen jeweils eine Stromspitze, so daß diese mit einer Frequenz von 10 MHz auftreten. Die Phasenverschiebung erfolgt mittels einer Verzögerungskette, die aus 15 Verzögerungsstufen besteht, die jeweils den Rechtecktakt um 2 ns verzögern. Ein dazu passender Zufallszahlengenerator erzeugt eine Zufallszahlenfolge mit 256 Werten, die sich mit einer Periodendauer Tn= 256T periodisch wiederholen. Die Zufallszahlenfolge kann dabei aus einer Tabelle ausgelesen oder mittels eines Pseudozufallsgenerators erzeugt werden. Das angegebene Beispiel führt zu einer Dichte der Spektrallinien mit einem Abstand von etwa 40 kHz untereinander. Wäre die Zufallszahlenfolge 10 mal so lang, dann würden die einzelnen Spektrallinien nur noch einen Abstand von etwa 4 kHz aufweisen.

Aus diesen Überlegungen folgen die wesentlichen Schaltungsteile der in den Figuren 1, 3 und 4 beschriebenen Taktgeneratoren tg. Jeder Taktgenerator enthält eine Taktquelle 1 zur Erzeugung eines Ursprungtaktes t1, der über die Folge der zugehörigen Schaltflanken einen Bezugstakt b1 definiert. In jedem Taktgenerator tg wird der Ursprungstakt t1 mittels eines von einer Signalquelle 3 bzw. 30 gesteuerten Phasenmodulators 2 bzw. 20 bzw. 25 moduliert, um einen gewünschten Systemtakt cl zu erzeugen. Dieser speist mindestens eine taktgesteuerte elektronische Einrichtung 5, z.B. einen Prozessor, dessen resultierende Stromspitzen i2 ein benachbartes elektronisches Gerät 6 stören können.

In Fig. 1 enthält der Phasenmodulator 2 eine variable Verzögerungseinrichtung 4, die den Ursprungstakt t1 entsprechend dem Wert eines Steuersignals s3 unterschiedlich verzögert. Die variable Verzögerungseinrichtung 4 kann z.B. eine analoge Laufzeitkette aus hintereinandergeschalteten Invertern sein, deren Verzögerungszeit von dem Steuersignal s3 abhängig ist. Damit sich das Steuersignal s3 während der Bezugstaktperiode T nicht ändert, wird es durch eine Abtasthalteschaltung 3.3 festgehalten. Das zugehörige Steuersignal s1 ist entweder der Ursprungstakt t1 oder ein verkoppeltes Signal aus der Taktquelle 1. Eine Zufallssignalquelle 3.1 in der Signalquelle 3 liefert an seinem Ausgang als Zufallssignal ein Rauschsignal ns, dessen Amplituden mittels eines Begrenzers 3.2 begrenzt werden. Sein Ausgangssignal ist ein gefiltertes Rauschsignal ns', das dem Eingang der Abtasthalteschaltung 3.3 zugeführt ist. Der Begrenzer 3.2 ist dann erforderlich, wenn der Zufallssignalquelle 3.1 nicht von sich aus in seiner Ausgangsamplitude begrenzt ist, weil dadurch zu große Phasendifferenzen auftreten könnten. Aus der eingangs genannten zweiten Bedingung ergibt sich nämlich, daß das Verhältnis der längsten Verzögerungszeit Tg/2 in einem bestimmten Verhältnis zur Periode T des Bezugstaktes b1 stehen muß, weil dadurch festgelegt wird, wie stark die Oberwellen des Bezugstaktes b1 gedämpft werden. Aus dieser Überlegung folgt, daß der Maximalwert Tg/2 der Phasendifferenz einen bestimmten Wert der Periode T des Bezugstaktes b1 nicht überschreiten darf. Dieser Wert liegt in der Regel zwischen 2 und 20 % der Periode T, sollte auf jeden Fall aber T/2 nicht überschreiten. In Fig. 3 und Fig. 4 ist eine variable Verzögerungseinrichtung 45 bzw. 40 aus einzelnen, digital gesteuerten Verzögerungsstufen 4d bzw. 4.1, 4.3, ..., 4.n mit gleichen oder ungleichen Verzögerungszeiten Δt bzw. Δt1, Δt2, .... Δtn, die aber auf jeden Fall fest sind, als Schaltbild dargestellt. Jede Verzögerungsstufe kann dabei durch eine eigene Laufzeitkette realisiert sein.

Fig. 2 zeigt schematisch für einige Perioden T den zeitlichen Verlauf einiger Signale. In der ersten Zeile ist der rechteckförmige Ursprungstakt t1 aus der Taktquelle 1 dargestellt. Da mit der positiven und negativen Flanke des Ursprungtaktes t1 jeweils ein Umschaltvorgang in der elektronischen Einrichtung 5 ausgelöst wird, ergibt sich für das Spektrum der resultierenden Stromspitzen i1 ein Bezugstakt b1 mit der doppelten Frequenz des Ursprungtaktes t1. In der vierten Zeile wird für jede Bezugstaktperiode T ein Zeitfenster Tg dargestellt, in dem infolge der Phasenmodulation die Stromspitzen i2 zu unterschiedlichen Zeiten auftreten können. Der halbe Wert des Zeitfensters Tg entspricht dabei der maximalen Phasendifferenz des Systemtaktes cl gegenüber dem Bezugstakt b1. Die zeitliche Dauer der Stromspitzen wird durch die Phasenmodulation nicht verändert.

In Figur 3 erzeugt der Phasenmodulator 20 quantisierte Phasendifferenzen Δt1, Δt2, ..., Δtn, deren Feinstruktur vom kleinsten Quantisierungsschritt der möglichen Phasendifferenzen abhängig ist. Der Phasenmodulator 20 arbeitet damit gleichsam digital, denn er kann nur eine bestimmte Anzahl von Phasendifferenzen erzeugen, die sich untereinander durch die jeweilige Anzahl der Phasendifferenzschritte Δt unterscheiden. Der Phasendifferenzschritt Δt kann beispielsweise durch die Signallaufzeit einer einzigen, oder um die Signalinvertierung zu vermeiden, einer doppelten Inverterstufe gebildet sein, die Teil einer Laufzeitkette aus hintereinandergeschalteten Inverterstufen sind. Bekanntlich kann die Laufzeit derartiger Inverterstufen über den Querstrom in einem weiten Bereich eingestellt werden, wobei mittels einer Regelschaltung herstellungs- oder temperaturbedingte Laufzeitabweichungen ausgeregelt werden können. Die Auswahl der jeweiligen Verzögerungszeit erfolgt mittels einer digital gesteuerten Schalteinrichtung 50, deren Signaleingänge mit jeweils einer Verzögerungsstufe 4.1, 4.2, 4.3, ..., 4.n verbunden sind. Durch ein digitales Steuersignal s4 wird jeweils einer der Eingänge der Schalteinrichtung 50 auf den Ausgang durchgeschaltet und gibt dort als Ausgangssignal den Systemtakt cl ab. Das digitale Steuersignal s4 wird von einer Zufallssignalquelle 30 gebildet, die am Ausgang diskrete Zufallszahlenwerte erzeugt. Bei den Zufallszahlenwerten handelt es sich in der Regel um eine Pseudozufallszahlenfolge aus einem Pseudozufallszahlengenerator, der beispielsweise in der bereits genannten DE-A 44 23 074 beschrieben ist. Es ist aber auch möglich, daß die Pseudozufahlszahlenfolge als Tabelle gespeichert ist, die von dem Zufallszahlengenerator 30 ausgelesen wird. Die Wiederholungsrate der Pseudozufallszahlenfolge ist durch die Länge der Tabelle oder die Anzahl der Schieberegisterstufen im Pseudozufallszahlengenerator beliebig vorgebbar. In Fig. 3 erfolgt die Ansteuerung des Zufallszahlengenerators 30 über den Ursprungstakt t1, der mittels einer Taktverdopplungsschaltung 1.1 verdoppelt wird und mit diesem Takt, dem Bezugstakt b1, den Zufallszahlengenerator 30 steuert.

In Fig. 4 ist ein Taktgenerator tg dargestellt, dessen Verzögerungsnetzwerk 45 besonders einfach zu realisieren ist. Es besteht aus der Hintereinanderschaltung einer vorgegebenen Anzahl von Verzögerungsstufen 4d mit jeweils gleichen Verzögerungszeiten Δt. Zwischen jeweils zwei Verzögerungsstufen befindet sich ein Signalabgriff, der mit jeweils einem Eingang einer elektronischen Schalteinrichtung 55 verbunden ist. Der Anfang und das Ende der Verzögerungskette sind ebenfalls mit Eingängen der Schalteinrichtung 55 verbunden. Jede Verzögerungsstufe 4d enthält eine gerade Anzahl von hintereinandergeschalteten Invertern, insbesondere zwei, wobei durch die gerade Anzahl eine Invertierung des Taktsignals verhindert werden soll. Die Ausbildung der Verzögerungseinrichtung als Inverterkette ist für die Schaltungsauslegung auf dem Halbleiterkristall besonders zweckmäßig, weil es sich bei den Verzögerungsstufen 4d um flächengleiche Schaltungsstrukturen handelt, die bequem in einem Block angeordnet werden können. Die einzelnen Transistoren der Schalteinrichtung 55 können dabei mit kurzen Signalleitungen an die Signalabgriffe der Verzögerungskette angeschlossen werden. Eine relativ kompakte Anordnung der Verzögerungseinrichtungen 4 bzw. 40 bzw. 45 auf der Halbleiteroberfläche ist wichtig, damit die zeitliche Auflösung des Systemtaktes cl nur von dem jeweiligen Signalabgriff und nicht von eingekoppelten Störsignalflanken abhängig ist. Die kleinsten Quantisierungsschritte und damit die Feinstruktur der Phasendifferenzen Δt bzw. Δϕ muß sehr klein gegenüber der Periode T des Bezugstaktes b1 sein. Für die Lösung der gestellten Aufgabe ist es ferner erforderlich, daß die Phasenverschiebung nur der Zufallszahl und nicht einem eingestreuten Signal folgt, das dann im Störspektrum wieder als hervorgehobenes Signal auftreten würde.

In Fig. 5 ist das Spektrum F(i1) der in der Frequenz und in der Phase festen Stromspitzen i1 schematisch dargestellt. Es enthält diskrete Spektrallinien, die mit der Frequenz f1 des Bezugstaktes b1 beginnen und sich über eine Vielzahl von Frequenzvielfachwerten von f1 erstrecken. Die Amplituden der Spektrallinien nehmen dabei mit steigender Frequenz ab. Dies hängt nach Fourier bekanntlich von dem Impuls/Pausenverhältnis und der Steilheit der Stromspitzen i1 ab. Diese Abhängigkeit ist schematisch als Pfeil f(i) dargestellt, der die Absenkung beeinflußt. In einem angenommenen Frequenzbereich fb sind die Amplituden der Spektralkomponenten noch relativ groß, so daß ein anderes elektronisches Gerät, das in diesem Frequenzbereich Störsignale aufnehmen könnte, unzulässig gestört würde.

In Fig. 6 ist schematisch das Störspektrum F(i2) der Stromspitzen i2 dargestellt, die nach der Erfindung aus einem phasenmodulierten Systemtakt cl resultieren. Im Frequenzbereich k1 fällt auf, daß die Absenkung der Frequenzvielfachwerte des Systemtaktes cl, die mit dem Vielfachen der Bezugstaktfrequenz f1 auftreten, deutlich höher ist als im Beispiel von Fig. 5. Im Frequenzbereich k2 wiederholt sich bei der Frequenz fw das Spektrum des Frequenzbereichs k1, wobei es sich symmetrisch zu höheren und tieferen Frequenzen erstreckt. Die Lage dieser Frequenz fw hängt, wie in Punkt 1 erörtert, von dem kleinsten gemeinsamen Vielfachen der inversen Verzögerungszeiten, also von dem kleinsten Verzögerungsschritt Δt ab. Diese Frequenz fw und damit der gesamte Frequenzbereich k2 sollen so hoch liegen, daß der kritische Frequenzbereich fb nicht mehr gestört wird.

Die Absenkung der Oberwellen im Frequenzbereich k1 und damit auch im Frequenzbereich k2 hängt entsprechend dem Punkt 2 der eingangs genannten Abhängigkeiten vom Verhältnis der längsten Verzögerungszeit Tg/2 zur Periodendauer T des Bezugstaktes b1 ab. Wenn das Verhältnis ausreichend groß ist, dann verschwindet bereits die Amplitude der Grundwelle - die bei der Bezugstaktfrequenz f1 liegt - im gleichförmigen Rauschpegel pn. Der Übersichtlichkeit wegen ist dieser Zustand in Fig. 6 jedoch nicht dargestellt.

Nach der Erfindung wird die gesamte Energie des störenden Spektrums möglichst gleichförmig auf eine Vielzahl von Frequenzen aufgeteilt, die in den Frequenzbereichen k1, k2 und k3 liegen. Die Amplituden der einzelnen Komponenten bilden dabei den gleichförmigen Rauschpegel pn, dessen Umhüllende in Fig. 6 schematisch als strichpunktierte Linie pn dargestellt ist. Je dichter die einzelnen Spektrallinien liegen, desto niedriger ist der Rauschpegel pn, weil sich die Energie auf mehr Spektralkomponenten aufteilen kann. Für die Dichte der Spektrallinien ist entsprechend dem eingangs erwähnten Punkt 3 die zeitliche Länge Tn der Zufallszahlenfolge im Verhältnis zur Periodendauer T des Bezugstaktes b1 verantwortlich. Die Wiederholungsrate der Pseudozufallszahlenfolge bestimmt die Anzahl der Spektrallinien im Frequenzbereich 0 bis fw, und damit ihre Dichte.

Über eine rechnerische Simulation lassen sich einzelne Parameter des Systemtaktes cl leicht variieren und ihr Einfluß auf das Störspektrum F(i2) und den Nutzsignalbereich fb untersuchen. Es lassen sich dabei optimale Parameter finden, die den gewünschten Entstöreffekt bringen. Die Übereinstimmung zwischen der tatsächlichen Entstörwirkung und der Simulation ist sehr hoch.

## Patentansprüche

1. Taktgenerator (tg) zur Erzeugung eines im zeitlichen Mittel frequenzgenauen Systemtaktes (cl) für eine taktgesteuerte elektronische Einrichtung (5), der bezüglich benachbarter elektronischer Geräte (6), insbesondere im Kraftfahrzeug, störstrahlarm ist, wozu der Taktgenerator (tg) einen in der Phase und Frequenz stabilen Ursprungstakt (t1), der einen Bezugstakt (b1) definiert, mittels eines Phasenmodulators (2; 20; 25) in Abhängigkeit von einer Signalquelle (3; 30) gegenüber dem Bezugstakt (b1) moduliert und daraus den Systemtakt (cl) erzeugt,
wobei
- die Signalquelle (3; 30) zur Steuerung der Phasenmodulation eine Zufallssignalquelle (3.1) enthält und ein Steuersignal erzeugt,
- der resultierende maximale Phasenhub (Δϕ bzw. Δt) auf einen Wert begrenzt ist, der kleiner als der halbe Wert einer Periode (T) des Bezugstaktes ist,
- die Zufallssignalquelle (3.1) als Ausgangssignal entweder
- ein analoges Ausgangssignal erzeugt, wodurch die statistische Verteilung der resultierenden Phasendifferenzen (Δϕ) kontinuierlich ist,
- oder ein digitales Ausgangssignal erzeugt, dessen Auflösung über die Größe der Quantisierungsschritte so fein vorgegeben ist, daß die resultierenden Phasendifferenzen (Δϕ) eine Feinstruktur aufweisen, die kleiner als ein Zehntel der Periode (T) des Bezugstaktes (b1) ist, und wobei der Phasen modulator den Ursprungtakt entsprechend dem Wert des Steuersignals unterschiedlich verzögert.

2. Taktgenerator (tg) nach Anspruch 1, **dadurch gekennzeichnet, daß** die Zufallssignalquelle (3.1.) ein periodisches, digitales Ausgangssignal erzeugt, das auch als Pseudozufallssignal bezeichnet wird, wobei die Periode (Tn) der Pseudozufallszahlenfolge größer als der zehnfache Wert der Periode (T) des Bezugstaktes (b1) ist.

3. Taktgenerator (tg) nach Anspruch 1 oder 2, **dadurch gekennzeichnet, daß** der Phasenmodulator (2; 20; 25) eine variable Verzögerungseinrichtung (4; 40; 45) enthält, deren Steuereingang mit dem Ausgang der Zufallssignalquelle (3.1) verkoppelt ist.

4. Taktgenerator (tg) nach Anspruch 3, **dadurch gekennzeichnet, daß** der Phasenmodulator (25; 20) ein mit Signalabgriffen versehenes Verzögerungsnetzwerk (45; 40) mit Verzögerungsstufen (4d bzw 4.1, 4.2, 4.3, 4.n) mit gleichen und/oder ungleichen Verzögerungszeiten (Δt bzw. Δt1, Δt2, Δt3, ... Δtn) und eine mit den Signalabgriffen verbundene Schalteinrichtung (55 bzw. 50) enthält und daß durch die Zufallszahlenwerte die jeweilige Schaltposition und damit die momentane Verzögerungszeit (Δti) des Verzögerungsnetzwerkes (45; 40) gesteuert ist.

## Claims

1. A clock generator (tg) for generating a stable-frequency system clock signal (cl) for a clock-controlled electronic device (5) which system clock signal (cl) causes minimum electromagnetic interference in nearby electronic equipment (6), particularly in motor vehicles, for which purpose the clock generator (tg) modulates, by means of a phase modulator (2; 20; 25) controlled by a signal source (3; 30), a basic clock signal (t1) of stable phase and frequency, which defines a reference clock (b1), with respect to the reference clock signal (b1), wherein
- the signal source (3; 30) comprises a random-signal source (3.1) and generates a control signal for controlling the phase modulation,
- the resulting maximum phase shift (Δϕ; Δt) is limited to a value which is less than half the value of a period (T) of the reference clock signal, and
- the random-signal source (3.1) generates
-- either an analog output signal, whereby the statistical distribution of the resulting phase differences (Δϕ) is continuous,
-- or a digital output signal whose resolution, which is predetermined via the size of the quantization steps, is so fine that the resulting phase differences (Δϕ) have a structure finer than one tenth of the period (T) of the reference clock signal (b1), and
wherein the phase modulator delays the basic clock signal by different amounts in accordance with the value of the control signal.

2. A clock generator (tg) as claimed in claim 1, **characterized in that** the random-signal source (3.1) generates a periodic, digital output signal, which is also referred to as a pseudorandom signal, with the period (Tn) of the pseudorandom-number sequence being greater than ten times the value of the period (T) of the reference clock signal (b1).

3. A clock generator (tg) as claimed in claim 1 or 2, **characterized in that** the phase modulator (2; 20; 25) comprises a variable delay device (4; 40; 45) whose control input is coupled to the output of the random-signal source (3.1).

4. A clock generator (tg) as claimed in claim 3, **characterized in that** the phase modulator (25; 20) contains a tapped delay network (45; 40) and a switching device (55; 50) connected to the taps, the delay network (45; 40) consisting of delay stages (4d; 4.1, 4.2, 4.3, ..., 4.n) providing equal and/or unequal delays (Δt; Δt1, Δt2, Δ3, ..., Δtn), and that the respective switch position, and thus the instantaneous delay (Δti) of the delay network (45; 40), is controlled by the values of the random numbers.

## Revendications

1. Générateur de signaux de cadencement (tg) pour la production d'un cadencement de système (c1) qui est exact en fréquence en moyenne dans le temps, qui est destiné à un dispositif électronique (5) qui est piloté par des signaux de cadencement et qui, en ce qui concerne des appareils électroniques voisins (6), en particulier dans un véhicule automobile, a un faible rayonnement de parasites, ce pour quoi le générateur de signaux de cadencement (tg) module un cadencement initial (t1), qui est stable en phase et en fréquence et qui définit un cadencement de référence (b1), au moyen d'un modulateur de phase (2 ; 20 ; 25), en fonction d'une source de signaux (3 ; 30), par rapport au cadencement de référence (b1) et produit, à partir du cadencement initial (t1), le cadencement de système (c1), générateur dans lequel :
- la source de signaux (3 ; 30) comprend, pour la commande de la modulation en phase, une source de signaux aléatoires (3.1) et produit un signal de commande,
- le déplacement de signal maximal résultant (Δϕ ou Δt) est limité à une valeur qui est plus petite que la moitié de la période (T) du cadencement de référence (b1)
- la source de signaux aléatoires (3.1) produit, en tant que signal de sortie :
- soit un signal de sortie analogique au moyen duquel la répartition statistique des différences de phase (Δϕ) résultantes est continue,
- soit un signal de sortie numérique dont la résolution est prédéterminée, par l'intermédiaire de la grandeur des pas de quantification, de manière tellement fine que les différences de phase (Δϕ) résultantes présentent une structure fine qui est plus petite qu'un dixième de la période (T) du cadencement de référence (b1), et dans lequel le modulateur de phase (2 ; 20 ; 25) temporise le cadencement initial (t1) de manière différente en correspondance avec la valeur du signal de commande.

2. Générateur de signaux de cadencement (tg) selon la revendication 1, **caractérisé en ce que** la source de signaux aléatoires (3.1) produit un signal de sortie numérique périodique, qui est également désigné par signal pseudo aléatoire, la période (Tn) de la suite de nombres pseudo aléatoires étant plus grande que dix fois la période (T) du cadencement de référence (b1).

3. Générateur de signaux de cadencement (tg) selon la revendication 1 ou 2, **caractérisé en ce que** le modulateur de phase (2 ; 20 ; 25) comprend un dispositif de temporisation variable (4 ; 40 ; 45) dont l'entrée de commande est raccordée à la sortie de la source de signaux aléatoires (3.1).

4. Générateur de signaux de cadencement (tg) selon la revendication 3, **caractérisé en ce que** modulateur de phase (20 ; 25) comprend un réseau de temporisation (45 ; 40) qui est muni de prises de signal et qui comporte des étages de temporisation (4d, resp.4.1, 4.2, 4.3,... 4.n) ayant des temps de temporisation (Δt, Δt1, Δt2, Δt3, ...,Δtn) égaux et/ou inégaux et un dispositif de commutation (55 ou 60) qui est relié aux prises de signal et **en ce que**, au moyen des valeurs de nombres aléatoires, on commande la position de commutation respective et, par suite, le temps de temporisation instantané (Δti) du réseau de temporisation (45 ; 40).
